# EUROPÄISCHE PATENTSCHRIFT

(11) **EP 0 769 196 B1**
(45) Veröffentlichungstag und Bekanntmachung des Hinweises auf die Patenterteilung: **23.09.1998**
(21) Anmeldenummer: 95924164.7
(22) Anmeldetag: 03.07.1995
(51) Int. Cl.: H01H 1/00

(54) **MIKROMECHANISCHES BAUELEMENT UND HERSTELLUNGSVERFAHREN**
MICROMECHANICAL COMPONENT AND PROCESS FOR PRODUCING THE SAME
COMPOSANT MICROMECANIQUE ET SON PROCEDE DE FABRICATION

(30) Priorität: 04.07.1994 DE 4423396
(43) Veröffentlichungstag der Anmeldung: 23.04.1997
(73) Patentinhaber: SIEMENS AKTIENGESELLSCHAFT, 80333 München (DE)
(72) Erfinder: KOZLOWSKI, Frank, D-82284 Grafrath (DE)
(86) Internationale Anmeldenummer: DE9500855
(87) Internationale Veröffentlichungsnummer: WO9601483

(56) Entgegenhaltungen:
- DE-A- 4 234 969
- DE-A- 4 332 843
- PROCEEDINGS IEEE MICRO ELECTRO MECHANICAL SYSTEMS. AN INVESTIGATION OF MICRO STRUCTURES, SENSORS, ACTUATORS, MACHINES AND ROBOTIC SYSTEMS (CAT. NO.94CH3404-1), PROCEEDINGS IEEE MICRO ELECTRO MECHANICAL SYSTEMS AN INVESTIGATION OF MICRO STRUCTURES, SE, ISBN 0-7803-1833-1, 1994, NEW YORK, NY, USA, IEEE, USA, Seiten 170-175, ELDERS J ET AL 'Materials analysis of fluorocarbon films for MEMS applications'
- JAPANESE JOURNAL OF APPLIED PHYSICS, PART 2 (LETTERS), 1 NOV. 1993, JAPAN, Bd. 32, Nr. 11A, ISSN 0021-4922, Seiten L1642-L1644, KOBAYASHI D ET AL 'Photoresist-assisted release of movable microstructures' in der Anmeldung erwähnt
- PATENT ABSTRACTS OF JAPAN vol. 017 no. 091 (E-1324) ,23.Februar 1993 & JP,A,04 286165 (RICOH CO LTD) 12.Oktober 1992,

## Beschreibung

Bei beweglichen Komponenten mikromechanischer Bauelemente, z. B. Sensoren oder Aktuatoren, tritt sowohl bei der Verwendung als auch bei der Herstellung das Problem auf, daß das bewegliche Teil auf der Unterlage haftenbleibt. Dieses sogenannte "sticking" tritt bei der Herstellung als Folge starker Kapillarkräfte während des Abtrocknens der bei und nach dem Ätzen verwendeten Flüssigkeiten auf. Bei der Verwendung des Bauelementes kann bei einer zu starken Auslenkung des beweglichen Teiles zum Substrat hin ein so inniger Kontakt zwischen diesem Teil und der Oberfläche des Substrates auftreten, daß sich das Teil nicht mehr von der Oberfläche ablöst.

In der Veröffentlichung von D. Kobayashi et al.:
"Photoresist-Assisted Release of Movable Microstructures" in Jpn. J. Appl. Phys. 32, L1642 - L1644 (1993) ist ein Verfahren beschrieben, mit dem unter Verwendung zusätzlicher Schichten aus Fotolack ein für ein mikromechanisches Bauelement vorgesehenes bewegliches Teil so festgehalten wird, daß ein naßchemischer Ätzprozeß erfolgen kann, ohne daß das bewegliche Teil auf der Unterlage haftenbleibt. Der Fotolack wird anschließend in einem Sauerstoff-Plasma durch Veraschen entfernt.

In der JP 4286165 sind ein mikromechanisches Bauelement und ein zugehöriges Herstellungsverfahren beschrieben. Das Bauelement trägt ein bewegliches Teil auf der Oberseite eines Substrates, die eine Rauigkeit aufweist. Die diese Rauigkeit bewirkenden Unebenheiten haben geringere Abmessungen als die minimale Abmessung des beweglichen Teiles. Zur Herstellung werden auf die rauhe Oberseite eine Opferschicht und eine für das bewegliche Teil vorgesehene weitere Schicht aufgebracht und strukturiert. Anschließend wird die Opferschicht entfernt. Die rauhe Oberseite befindet sich dann unter dem beweglichen Teil.

Aufgabe der vorliegenden Erfindung ist es, ein mikromechanisches Bauelement, bei dem ein Kleben eines beweglichen Abschnitts der Oberflächenstruktur an dem Substrat verhindert ist, und ein zugehöriges Herstellungsverfahren dafür anzugeben.

Diese Aufgabe wird mit dem Bauelement mit den Merkmalen des Anspruches 1 und mit dem Herstellungsverfahren mit den Merkmalen des Anspruches 2 gelöst. Weitere Ausgestaltungen ergeben sich aus den abhängigen Ansprüchen.

Bei dem erfindungsgemäßen Bauelement sind zwischen dem Substrat und dem beweglichen Abschnitt der mikromechanischen Struktur auf der Oberfläche des Substrates kleine Abstandshalter aus einem separat aufgebrachten Material vorhanden. Durch diese Abstandshalter wird die Oberseite des Substrates so uneben, daß der bewegliche Abschnitt, d. h. die bewegliche Komponente des Bauelementes nur an wenigen Stellen mit diesen Abstandshaltern in Berührung kommen kann, so daß ein Ankleben auf der Unterlage verhindert ist.

Diese Abstandshalter werden vorzugsweise hergestellt, nachdem eine Opferschicht (sacrificial layer) und eine für die Herstellung des beweglichen Teiles vorgesehene Strukturschicht auf ein Substrat abgeschieden worden sind, die Strukturschicht entsprechend dem herzustellenden beweglichen Abschnitt strukturiert worden ist und die Opferschicht zumindest in den für die Abstandshalter vorgesehenen Bereichen zumindest teilweise entfernt worden ist. Vorzugsweise verbleibt ein Rest der Opferschicht als Stütze für das bewegliche Teil zwischen der Strukturschicht und dem Substrat, während die Herstellungsschritte für die Herstellung der Abstandshalter durchgeführt werden. Es wird dann eine Schicht aus einem Material, das für die Abstandshalter vorgesehen ist, so abgeschieden, daß Anteile davon zwischen den für den beweglichen Abschnitt vorgesehenen Bereich der Strukturschicht und das Substrat gelangen. Die zuvor naßchemisch entfernten Anteile der Opferschicht werden auf diese Weise zumindest teilweise wieder aufgefüllt. Wenn noch verbleibende Anteile der Opferschicht anschließend entfernt werden müssen, wird das Material, das für die Abstandshalter abgeschieden wird, so gewählt, daß es gegen diesen nachfolgenden Ätzprozeß resistent ist. Wenn die Bedingungen bei der Abscheidung der Schicht so gewählt worden sind, daß die Dicke der Schicht unterhalb des für den beweglichen Abschnitt vorgesehenen Anteils der Strukturschicht aufgrund der abschattenden Wirkung der Strukturschicht geringer ist als die Schichtdicke an den frei zugänglichen Stellen, kann die mikromechanische Struktur, d. h. insbesondere der bewegliche Abschnitt, nach dem Entfernen der überschüssigen Schichtanteile nur noch punktuell mit dem Untergrund in Beruhrung kommen. Falls die mikromechanischen Elemente bereits vollständig freigelegt sind, der betreffende Abschnitt der Strukturschicht also frei beweglich ist, muß die für die Abstandshalter abgeschiedene Schicht nicht gegen Ätzmittel resistent sein. Vorzugsweise wird als Material für diese Schicht Fluorkohlenstoff verwendet, der z. B. in einem Plasma-Reaktor unter der Wirkung eines elektrischen Feldes abgeschieden werden kann.

Es folgt eine genauere Beschreibung der Erfindung anhand der Figuren 1 bis 4.
Figuren 1 bis 3 zeigen Zwischenprodukte eines erfindungsgemäßen Bauelementes im Querschnitt nach verschiedenen Schritten des Herstellungsverfahrens.
Figur 4 zeigt ein Zwischenprodukt eines erfindungsgemäßen Bauelementes nach einem alternativen Herstellungsschritt.

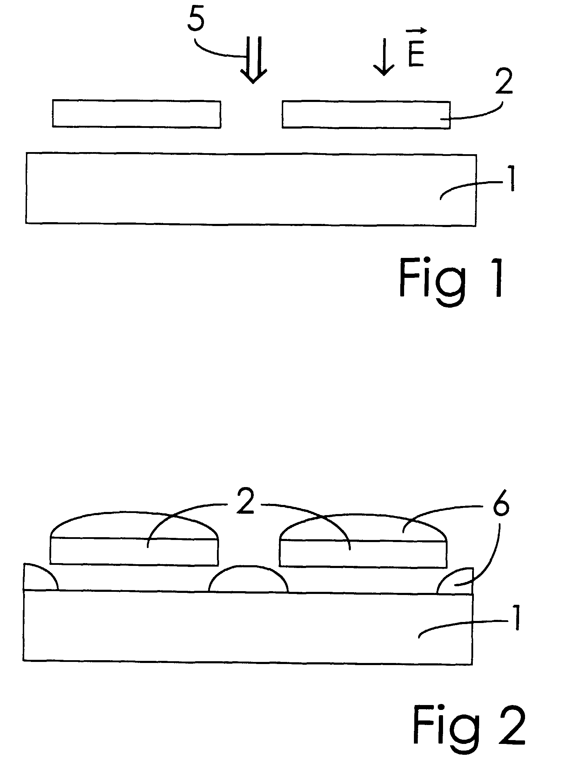

In Figur 1 ist über einem Substrat 1, das eine Halbleiterscheibe, eine Halbleiterschichtstruktur oder dergleichen sein kann, ein beweglicher Abschnitt 2, d. h. ein bewegliches Teil des mikromechanischen Bauelementes, im Abstand zu diesem Substrat 1 dargestellt. Der Einfachheit halber sind die Aufhängungen dieses Abschnittes 2 und die in Blickrichtung hinter der Zeichenebene angeordneten Anteile des Bauelementes weggelassen. Diese Struktur wird z. B. wie eingangs beschrieben hergestellt, indem auf das Substrat 1 eine Opferschicht und darauf eine Strukturschicht aus dem für das bewegliche Teil vorgesehenen Material aufgebracht werden. Die Strukturschicht wird entsprechend dem vorgesehenen Bauelement strukturiert; dann wird die Opferschicht entfernt. Dann wird näherungsweise in Richtung des in Figur 1 eingezeichneten Doppelpfeiles 5 das für die Abstandshalter vorgesehene Material als Schicht aufgebracht. Die Abscheidung erfolgt dabei nicht vollständig anisotrop, sondern divergent, so daß Anteile der aufgebrachten Schicht 6 wie in Figur 2 gezeigt auch unterhalb des beweglichen Abschnittes 2 aufgebracht werden. Bei einer Abscheidung in einem Plasma-Reaktor kann die Abscheidung z. B. durch ein auf das Substrat 1 gerichtetes elektrisches Feld, das in Figur 1 mit dem einfachen Pfeil eingezeichnet ist, unterstützt werden.

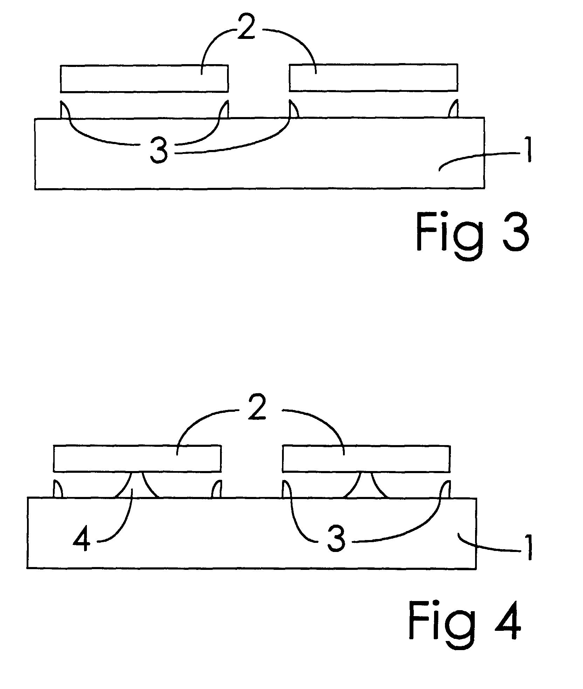

Die abgeschiedene Schicht 6 ist z. B. vorzugsweise Fluorkohlenstoff. Entsprechend der Darstellung der Figur 2 wird durch die leicht divergente Abscheidung erreicht, daß diese Schicht sich in Form von ersten unebenen Schichtanteilen auf dem Substrat und in Form von zweiten Schichtanteilen auf dem beweglichen Abschnitt 2 niederschlägt. Wenn die Abscheidebedingungen so gewählt sind, daß die Schichtdicke unter dem beweglichen Abschnitt 2 dünner ist als diejenige an den frei zugänglichen Stellen, was aus der abschattenden Wirkung des beweglichen Abschnittes 2 resultiert, so kann anschließend der bewegliche Abschnitt nur noch an wenigen Stellen (punktuell) mit dem Untergrund in Berührung kommen. Es ist möglich, das Verfahren in dem Zustand abzubrechen, der in Figur 2 dargestellt ist, da bereits hier ein Ankleben der beweglichen Abschnitte der mikromechanischen Struktur auf dem Untergrund vermieden ist. Falls die zweiten Schichtanteile auf der Oberseite des beweglichen Abschnittes stören, wird ein stark anisotropes Ätzen dieser Schicht 6 durchgeführt, wodurch erreicht wird, daß nur die in Figur 3 gezeichneten kleinen Abstandshalter 3 übrigbleiben.

Figur 3 zeigt ein Ausführungsbeispiel des erfindungsgemäßen Bauelementes im Querschnitt. Bei einer Bewegung der beweglichen Abschnitte 2 verhindern die Abstandshalter 3 eine Berührung der beweglichen Abschnitte mit dem Substrat. Die Abstandshalter sind so klein, daß die mögliche Berührungsfläche zwischen den Abstandshaltern und dem beweglichen Abschnitt so gering ist, daß der bewegliche Abschnitt beim Betrieb des Bauelementes nicht an den Abstandshaltern haftenbleibt. Durch die Abstandshalter wird ebenfalls eine Berührung zwischen dem beweglichen Abschnitt und dem Substrat verhindert.

Figur 4 zeigt ein Zwischenprodukt bei der Herstellung eines erfindungsgemäßen Bauelementes nach der Herstellung der Abstandshalter im Querschnitt. Es sind bei dieser Ausführungsform Reste 4 der Opferschicht zwischen der Strukturschicht und dem Substrat übriggeblieben. Diese Reste 4 stützen den für den beweglichen Abschnitt vorgesehenen Anteil der Strukturschicht 2 ab, bis die Abstandshalter 3 hergestellt sind. Die Reste 4 verhindern, daß die Strukturschicht beim Abtrocknen der für das Entfernen der Opferschicht verwendeten naßchemischen Ätzlösung auf der Oberseite des Substrates klebenbleibt. Außerdem wird eine Bewegung der strukturierten Abschnitte während der Herstellung der Abstandshalter verhindert. Die Reste 4 der Opferschicht können entfernt werden, bevor oder nachdem ein anisotropes Ätzen zum Herstellen der kleinen Abstandshalter und zum Entfernen der auf der Strukturschicht abgeschiedenen Anteile der Schicht 6 erfolgt ist. Statt der Reste der Opferschicht können z. B. provisorische Abstandshalter aus Fotolack, PMMA oder ein Polymer, vorzugsweise z. B. Polystyrol, z. B. entsprechend der eingangs erwähnten Veröffentlichung von Kobayashi, verwendet werden. Vorzugsweise wird das erfindungsgemäße Bauelement in Silizium hergestellt.

## Patentansprüche

1. Mikromechanisches Bauelement mit einem über einem Substrat (1) in einem Abstand angeordneten beweglichen Abschnitt (2) einer mikromechanischen Struktur,
bei dem Abstandshalter (3) auf einer diesem beweglichen Abschnitt zugewandten Oberseite dieses Substrates zwischen diesem beweglichen Abschnitt und dieser Oberseite vorhanden sind,
bei dem diese Abstandshalter so bemessen sind, daß ein Ankleben des beweglichen Abschnittes am Substrat oder an den Abstandshaltern verhindert ist, und
bei dem diese Abstandshalter aus einem Fluorkohlenstoff sind.

2. Verfahren zur Herstellung eines mikromechanischen Bauelementes nach Anspruch 1 mit folgenden Schritten:
a) Auf ein Substrat werden eine Opferschicht und eine Strukturschicht aufgebracht;
b) diese Strukturschicht wird entsprechend einem herzustellenden beweglichen Abschnitt strukturiert;
c) diese Opferschicht wird zwischen diesem Abschnitt und dem Substrat zumindest teilweise entfernt;
d) zwischen diesen Abschnitt und das Substrat werden Anteile einer Schicht aus einem für Abstandshalter vorgesehenen Fluorkohlenstoff abgeschieden;
e) diese Schicht wird auf die vorgesehenen Abstandshalter rückgeätzt.

3. Verfahren nach Anspruch 3,
bei dem in Schritt d unter Ausnutzung der abschattenden Wirkung des für den beweglichen Abschnitt vorgesehenen Anteils der Strukturschicht die Schicht aus Fluorkohlenstoff mit einer Unebenheit der Schichtdicke abgeschieden wird.

4. Verfahren nach Anspruch 2 oder 3,
bei dem in Schritt d die Abscheidung als divergente Abscheidung von Fluorkohlenstoff in einem Plasma-Reaktor unter der Wirkung eines gegen das Substrat gerichteten elektrischen Feldes (E) durchgeführt wird.

5. Verfahren nach einem der Ansprüche 2 bis 4,
bei dem in Schritt c die Opferschicht mit Ausnahme von zwischen dem für den beweglichen Abschnitt vorgesehenen Anteil der Strukturschicht und dem Substrat verbleibenden Resten (4), die ein Ankleben des beweglichen Abschnittes am Substrat oder an den Abstandshaltern während der Schritte d und e verhindern, entfernt wird, und
bei dem nach Schritt e in einem weiteren Schritt f diese Reste der Opferschicht entfernt werden.

## Claims

1. Micromechanical component having a movable section (2), arranged at a distance over a substrate (1), of a micromechanical structure,
in which spacers (3) are present on a top side, facing said movable section, of said substrate, between said movable section and said top side,
in which said spacers are dimensioned in such a way that sticking of the movable section to the substrate or to the spacers is prevented, and
in which said spacers are made of a fluorocarbon.

2. Method for the production of a micromechanical component according to Claim 1, having the following steps:
a) a sacrificial layer and a structure layer are applied to a substrate;
b) said structure layer is structured in accordance with a movable section to be produced;
c) said sacrificial layer is at least partially removed between said section and the substrate;
d) portions of a layer made of a fluorocarbon provided for spacers are deposited between said section and the substrate;
e) said layer is etched back to the envisaged spacers.

3. Method according to Claim 2,
in which, in step d, the layer made of fluorocarbon is deposited with an uneven layer thickness by utilizing the shading effect of that portion of the structure layer which is provided for the movable section.

4. Method according to Claim 2 or 3,
in which, in step d, the deposition is carried out as the divergent deposition of fluorocarbon in a plasma reactor under the action of an electric field (E) directed towards the substrate.

5. Method according to one of Claims 2 to 4,
in which, in step c, the sacrificial layer is removed, with the exception of residues (4) which remain between that portion of the structure layer which is provided for the movable section and the substrate and prevent sticking of the movable section to the substrate or to the spacers during steps d and e, and
in which, after step e, these residues of the sacrificial layer are removed in a further step f.

## Revendications

1. Composant micromécanique comprenant une partie (2) mobile d'une structure micromécanique disposée de manière écartée au-dessus d'un substrat (1),
dans lequel des écarteurs (3) sont ménagés sur une face supérieure de ce substrat orientée vers ladite partie mobile entre ladite partie mobile et ladite face supérieure,
dans lequel ces écarteurs sont dimensionnés de telle sorte qu'un collage de cette partie mobile sur le substrat ou sur les écarteurs est empêché, et
dans lequel ces écarteurs sont en carbone fluoré.

2. Procédé de fabrication d'un composant micromécanique selon la revendication 1, comprenant les étapes suivantes:
a) une couche sacrificielle et une couche structurelle sont déposées sur un substrat;
b) cette couche structurelle est structurée conformément à une partie mobile à fabriquer;
c) cette couche sacrificielle est enlevée du moins partiellement entre cette partie et le substrat;
d) des parties d'une couche en carbone fluoré prévue pour les écarteurs sont déposées entre cette partie et le substrat;
e) cette couche est gravée en retrait sur les écarteurs prévus.

3. Procédé selon la revendication 2, dans lequel, dans l'étape d, la couche en carbone fluoré est déposée avec une irrégularité de l'épaisseur en utilisant l'effet d'ombrage de la partie de la couche structurelle prévue pour la partie mobile.

4. Procédé selon la revendication 2 ou 3, dans lequel, dans l'étape d, le dépôt est un dépôt divergent de carbone fluoré, effectué dans un réacteur à plasma sous l'action d'un champ électrique (E) dirigé vers le substrat.

5. Procédé selon l'une des revendications 2 à 4, dans lequel, dans l'étape c, on procède à l'enlèvement de la couche sacrificielle, à l'exception des restes (4) demeurant entre la partie de la couche structurelle prévue pour la partie mobile et le substrat, qui empêchent un collage de la partie mobile sur le substrat ou sur les écarteurs pendant les étapes d et e, et
dans lequel, après l'étape e, ces restes de la couche sacrificielle sont enlevés dans une étape suivante f.
